# FASCICULE DE BREVET EUROPEEN

(11) **EP 3 454 122 B1**
(45) Date de publication et mention de la délivrance du brevet: **19.02.2020**
(21) Numéro de dépôt: 17190404.8
(22) Date de dépôt: 11.09.2017
(51) Int. Cl.: G03F 7/00, C25D 1/00, C25D 5/02, G03F 7/16

(54) **PROCEDE DE FABRICATION PAR TECHNOLOGIE LIGA D'UNE MICROSTRUCTURE METALLIQUE COMPORTANT AU MOINS DEUX NIVEAUX**
HERSTELLUNGSVERFAHREN MITHILFE DER LIGA-TECHNOLOGIE EINER METALL-MIKROSTRUKTUR MIT MINDESTENS ZWEI STUFEN
METHOD FOR MANUFACTURING A METAL MICROSTRUCTURE USING LIGA TECHNOLOGY, COMPRISING AT LEAST TWO LEVELS

(43) Date de publication de la demande: 13.03.2019
(73) Titulaire: Patek Philippe SA Genève, 1204 Genève (CH)
(72) Inventeur: GUILLOT, Laurent, 25300 Pontarlier (FR); JEANNERET, Sylvain, 2013 Colombier (CH)
(74) Mandataire: Micheli & Cie SA

(56) Documents cités:
- EP-A1- 2 157 476
- EP-A1- 2 263 972
- EP-A2- 1 462 859

## Description

### DOMAINE DE L'INVENTION

La présente invention concerne un procédé de fabrication d'une microstructure métallique multi-niveaux par une technologie de type LIGA, et elle concerne en particulier la mise en oeuvre d'un tel procédé pour fabriquer des pièces de micromécanique horlogère, le procédé comporte les étapes suivantes :
a. se munir d'un substrat comportant une face supérieure électriquement conductrice ;
b. déposer une première couche de résine photosensible sur la face supérieure du substrat ;
c. structurer la première couche de résine photosensible, afin de réaliser un premier niveau d'un moule multi-niveaux comportant des cavités traversantes laissant apparaître la surface conductrice du substrat ;
d. déposer une nouvelle couche de résine photosensible sur le niveau réalisé du moule multi-niveaux, de manière à le recouvrir et à remplir les cavités ;
e. structurer la nouvelle couche de résine photosensible afin de réaliser un niveau additionnel du moule multi-niveaux comportant des cavités traversantes laissant apparaître la surface conductrice du substrat ;
f. une surface électriquement conductrice ayant été préalablement formée, durant une étape antérieure, sur les portions accessibles du dessus du premier niveau du moule multi-niveaux, remplir de métal les cavités du moule multi-niveaux par dépôt galvanique de manière à former une structure métallique multi-niveaux ;
g. libérer la structure métallique multi-niveaux du substrat et de la résine photosensible.

### ART ANTERIEUR

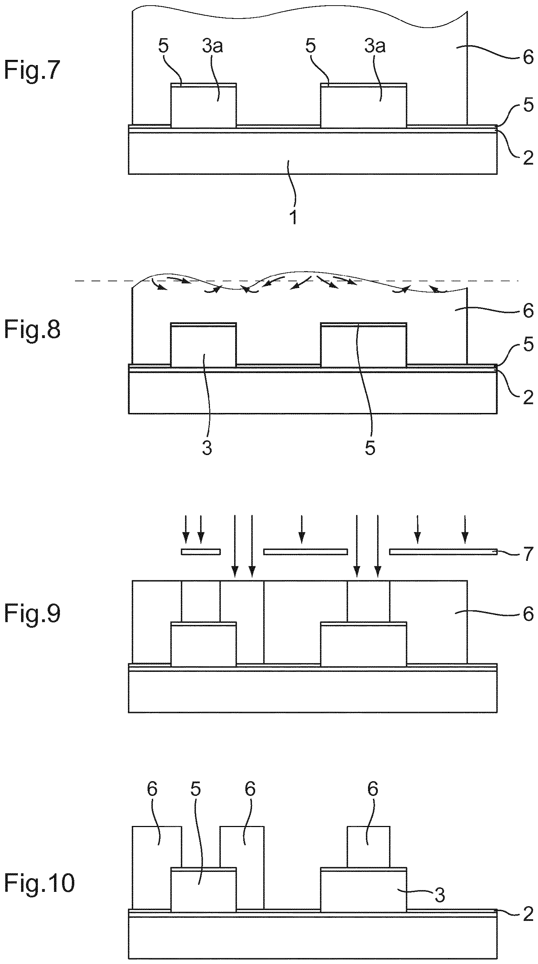

On connaît des procédés de fabrication de microstructures métalliques multi-niveaux conformes à la définition donnée ci-dessus. On trouve notamment la description d'un tel procédé dans le document de brevet EP 2 316 056 B1. Le procédé divulgué par ce document présente certains défauts. En effet, il prévoit notamment une étape qui consiste à déposer une nouvelle couche de résine photosensible sur la première couche de résine déjà structurée. Or, l'expérience montre qu'il est en fait très difficile de déposer une couche de résine photosensible sur une surface préalablement structurée. Comme le montrent d'ailleurs les figures 7 à 11 du document antérieur susmentionné, l'épaisseur de la nouvelle couche de résine présente un profil extrêmement irrégulier avec des parties beaucoup plus épaisses que d'autres. Ainsi, en raison de la présence d'endroits où la couche de résine est considérablement plus épaisse que nécessaire, le masque à travers lequel on irradie ensuite la couche de résine photosensible doit être positionné plus loin du substrat que normalement nécessaire. Il en résulte une moins bonne résolution du procédé photo-lithographique et donc des microstructures ayant des dimensions moins précises.

### BREF EXPOSE DE L'INVENTION

Un but de la présente invention est de remédier au problème qui vient d'être décrit. La présente invention atteint ce but ainsi que d'autres en fournissant un procédé de fabrication par technologie LIGA d'une microstructure métallique multi-niveaux, qui est conforme à la revendication 1 annexée.

Conformément à l'invention, le procédé comporte une étape de placer le substrat avec les couches de résines photosensibles dans une étuve sous vide pour une durée définie. Cette étape additionnelle permet à la fois de niveler la nouvelle couche de résine photosensible et d'éliminer les bulles d'air formées dans l'épaisseur de résine lors du dépôt de la couche. Grâce à la bonne planéité de la nouvelle couche résultant de cette étape, il est possible de garantir une résolution homogène, une bonne définition des contours de chaque niveau du moule, et des parois bien verticales. L'homme du métier comprendra que de tels avantages ont encore plus d'importance lorsque la microstructure à fabriquer est une pièce de micromécanique destinée par exemple à être montée dans une pièce d'horlogerie.

Ladite durée définie, durant laquelle le substrat et les couches de résines photosensibles séjournent dans l'étuve sous vide, dépend principalement de la topographie et de la géométrie des composants à réaliser. Elle dépend également de l'épaisseur de la couche et de la viscosité de la résine photosensible. Précisons de plus que l'étape qui vient d'être décrite est de préférence réalisée à température ambiante.

Conformément à une variante avantageuse du procédé de l'invention, suite à l'étape décrite ci-dessus, le procédé comporte encore une étape consistant à effectuer dans l'étuve sous vide un précuit de la nouvelle couche de résine avant de passer à l'étape e) du procédé.

### BREVE DESCRIPTION DES FIGURES

D'autres caractéristiques et avantages de la présente invention apparaîtront à la lecture de la description qui va suivre, donnée uniquement à titre d'exemple non limitatif, et faite en référence aux dessins annexés dans lesquels :

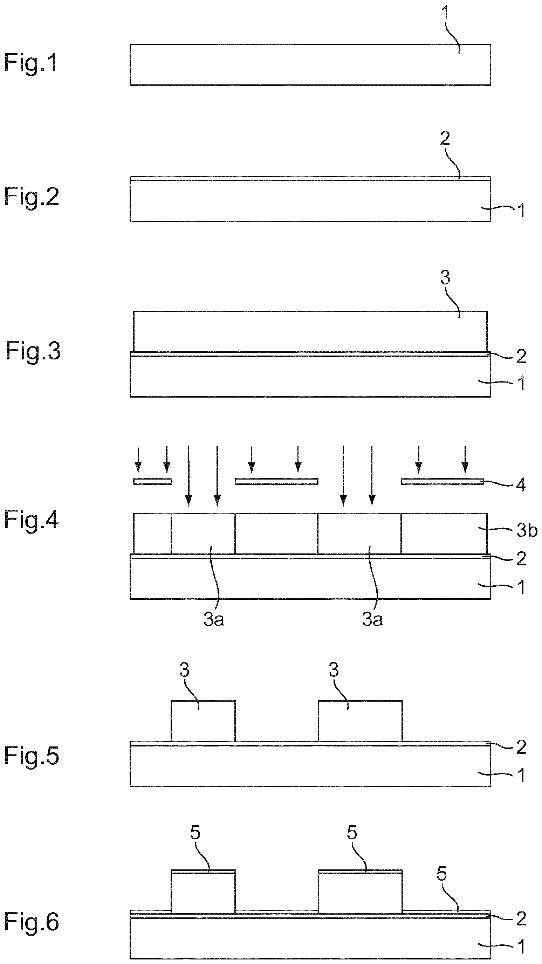

- les figures 1 à 14 illustrent schématiquement différentes étapes d'un procédé conforme à un mode de mise en œuvre particulier de l'invention.

### DESCRIPTION DETAILLEE D'UN MODE DE MISE EN ŒUVRE

Certaines étapes du procédé qui va être décrit sont déjà connues en tant que telles, notamment du document de brevet EP 2 316 056 B1 déjà mentionné.

Conformément à l'invention, le procédé comporte l'étape a) de se munir d'un substrat comportant une face supérieure électriquement conductrice. Dans le mode d'implémentation qui fait l'objet du présent exemple, le substrat 1 est constitué par une plaquette de silicium (fig. 1) dont l'épaisseur est comprise entre 0.5mm et 3mm et sur laquelle on a préalablement déposé par PVD ou CVD une couche conductrice 2 (fig. 2). Cette couche peut avantageusement être formée d'une sous-couche de chrome ou de titane recouverte d'une couche d'or ou de cuivre. Précisons toutefois que, lorsque le substrat est constitué par une plaquette en silicium comme c'est le cas ici, on peut alternativement obtenir la couche électriquement conductrice en dopant superficiellement le silicium de la face supérieure de la plaquette de manière à le rendre conducteur. Quelle que soit précisément sa nature, la couche électriquement conductrice 2 est destinée à servir de couche d'amorçage, c'est-à-dire de cathode lors d'un dépôt galvanique ultérieur.

Alternativement, le substrat peut être constitué d'une plaque de verre ou de céramique, ou même d'une plaque en métal, en acier inoxydable par exemple. On comprendra que dans ce dernier cas, il n'est pas indispensable de déposer une couche conductrice. Toutefois, la surface de la plaque en inox devra en général être traitée, voire activée chimiquement ou physiquement avant usage.

L'étape suivante (l'étape b) ; fig. 3) consiste à recouvrir la surface conductrice du substrat d'une première couche de résine photosensible 3. La résine utilisée est de préférence un photorésist négatif qui est conçu pour polymériser sous l'action d'un rayonnement UV. A titre d'exemple, on peut utiliser comme photorésist négatif le SU-8 commercialisé par Shell Chemical. Alternativement, la résine photosensible pourrait être un photorésist positif conçu pour se décomposer sous l'action d'un rayonnement UV. On comprendra que la présente invention ne se limite pas à quelques types particuliers de résines photosensibles. L'homme du métier saura choisir une résine photosensible convenant à ses besoins parmi toutes les résines connues qui sont adaptées à la photolithographie par UV.

La résine 3 peut être déposée sur la couche d'amorçage 2 à l'aide de toute technique connue de l'homme du métier; par exemple, à la tournette (spin coating), par application au cylindre, ou encore par laminage lorsqu'il s'agit d'une résine «solide», etc. L'épaisseur de la couche de résine photosensible 3 est typiquement comprise entre 20 et 500 microns. Selon l'épaisseur et la technique utilisée, la résine pourra être déposée en une ou plusieurs fois.

Selon une variante particulière du procédé de l'invention, une fois la couche de résine 3 déposée, elle subit encore un précuit au cours duquel elle est chauffée et maintenue entre 90 et 120° C pendant une durée suffisante pour évaporer les solvants (pre-bake). L'homme du métier comprendra toutefois que selon la nature de la résine utilisée, cette étape de précuit n'est pas forcément nécessaire.

L'étape suivante du procédé (l'étape c) comprend une sous-étape consistant à irradier la couche de résine 3 au moyen d'un rayonnement UV à travers les ouvertures d'un masque 4 définissant le contour du premier niveau de la microstructure désirée (fig. 4). L'ampleur de l'irradiation dépend de l'épaisseur de la résine. Elle est typiquement comprise entre 100 et 1000mJ/cm². Le cas échéant, un recuit de la couche (post-bake) peut être nécessaire pour compléter la polymérisation induite par l'irradiation UV. Avec une résine comme le SU-8 qui est utilisé dans le présent exemple, l'étape de recuit est de préférence effectuée entre 80 et 140°C durant 15 à 30 minutes. Les zones insolées (photopolymérisées) 3a deviennent ainsi insensibles à une grande majorité des liquides de développement. Par contre, les zones non insolées 3b pourront ultérieurement être dissoutes en utilisant un liquide de développement adéquat.

L'étape c) comprend ensuite une autre sous-étape consistant à développer la couche de résine photosensible 3 (fig. 5). Pour le développement du photorésist négatif du présent exemple, on utilise de préférence un solvant du type PGMEA qui a pour effet de dissoudre les zones non insolées 3b et à faire apparaître par endroit la couche conductrice 2 du substrat 1. On comprendra toutefois que, de manière connue en soi, dans le cas d'un photorésist positif, ce serait les zones insolées 3a qui seraient dissoutes. Quel que soit le type de photorésist utilisé, selon une variante avantageuse, il est possible de parachever l'étape de développement par une brève exposition à un plasma de manière à bien nettoyer le moule en résine et à en activer la surface en prévision de l'étape suivante.

Selon une variante avantageuse de mise œuvre du procédé de l'invention, l'étape qui vient d'être décrite, consistant à structurer la première couche de résine photosensible, est réalisée de manière à ce que les flancs du premier niveau du moule soient légèrement en surplomb. Pour obtenir des flancs légèrement en surplomb, on peut par exemple opérer un durcissement de la résine en surface, avant ou après développement de celle-ci par un traitement chimique ou physique tel qu'une exposition UV en deux temps ou un choc thermique.

Conformément au présent exemple, l'étape c) est suivie d'une étape consistant à rendre conductrices les parties subsistantes de la surface de la couche de résine développée à l'étape précédente (fig. 6). Pour ce faire on procède à un dépôt directionnel d'une couche de métallisation 5, par vaporisation sous vide (PVD ou CVD) par exemple. Les métaux utilisés pour former la couche de métallisation peuvent par exemple être le chrome et l'or. On peut voir sur la figure 6 que la couche de métallisation 5 ne recouvre de préférence que les surfaces horizontales, de sorte que les flancs demeurent isolants. On comprendra que, si du métal vient se déposer sur les flancs lors du processus de dépôt directionnel de la métallisation, ce métal situé sur les flancs peut ensuite engendrer des croissances parasites lors de l'étape d'électrodéposition. Ainsi, on comprendra que le fait de structurer la première couche de résine avec des flancs légèrement en surplomb a pour but de réduire, voire de supprimer, la probabilité que du métal vienne se déposer sur les flancs. Toutefois, selon une variante non représentée, la métallisation pourrait être réalisée sur les surfaces verticales aussi bien que sur les surfaces horizontales.

L'étape suivante du procédé (l'étape d) ; fig. 7) consiste à déposer une nouvelle couche de résine photosensible 6 sur la couche de métal vaporisé 5, de manière à recouvrir cette dernière et à remplir les ouvertures dans la couche de résine développée 3. Pour cette étape, il est préférable que les ouvertures formées dans la couche de résine déjà développée 3 soient bien remplies par la résine provenant de la nouvelle couche 6. Il est en général très difficile de déposer une couche de résine photosensible sur une surface préalablement structurée comme c'est le cas dans le présent exemple. Ainsi, comme le montre la figure 7, l'épaisseur de la nouvelle couche de résine 6 a tendance à présenter un profil extrêmement irrégulier avec des parties beaucoup plus épaisses que d'autres.

L'étape suivante du procédé (l'étape x) ; fig. 8) consiste à mettre à plat la nouvelle couche de résine photosensible 6. Ce résultat est obtenu en faisant séjourner un certain temps le substrat 2 et les couches de résines photosensibles 3 et 6 dans une étuve (non représentée), à l'intérieur de laquelle on a fait le vide. Le but de cette étape est d'aplanir la surface supérieure de la nouvelle couche de résine photosensible 6. La durée du séjour dans l'étuve peut varier de quelques minutes à plusieurs heures en fonction de la topographie et de la géométrie des structures à réaliser, de l'épaisseur de la couche de résine photosensible 6, ainsi que de sa viscosité. L'homme du métier n'aura pas de problèmes pour déterminer empiriquement la durée du séjour dans l'étuve sur la base de quelques essais.

La demanderesse a découvert que, de manière tout à fait surprenante, l'étape d'étuvage sous vide qui vient d'être décrite suffit pour égaliser sensiblement la surface bosselée de la couche de résine 6. Il s'avère que l'étape d'étuvage permet non seulement de niveler efficacement la nouvelle couche de résine photosensible, mais également d'éliminer les bulles d'air qui se sont formées lors du dépôt de la couche de résine. Grâce à la bonne planéité résultant de cette étape, il est possible de garantir une résolution homogène pour la lithographie, une bonne définition des contours de chaque niveau, et des cavités avec des parois bien verticales.

L'étape de mise à plat de la couche de résine photosensible est réalisée de préférence à température ambiante. Toutefois, selon un mode de mise en œuvre avantageux, l'étape de mise à plat à température ambiante est suivie d'une étape consistant à effectuer ensuite, dans la même étuve sous vide, un précuit de la nouvelle couche de résine.

L'étape suivante du procédé (l'étape e)) comprend une sous-étape consistant à irradier la nouvelle couche de résine 6 au moyen d'un rayonnement UV à travers les ouvertures d'un masque 7 définissant le contour du deuxième niveau de la microstructure désirée (fig. 9). Cette étape nécessite d'aligner le masque 7 avec les ouvertures du premier niveau. L'homme du métier saura réaliser cet alignement, en se servant par exemple de marques d'alignement. Finalement, comme déjà décrit plus haut, selon la nature de la résine photosensible utilisée, l'étape d'insolation est suivie par une étape de recuit de l'ensemble pour parachever la polymérisation induite par l'irradiation UV.

L'étape e) comprend ensuite une autre sous-étape consistant à développer la nouvelle couche de résine photosensible irradiée 6. La technique peut être la même que celle utilisée pour développer la première couche 3. L'étape de développer la couche de résine 6 produit un moule à deux niveaux en résine comme celui de la figure 10. On précisera en outre que l'étape décrite plus haut consistant à déposer une couche de métallisation 5, par exemple par vaporisation sous vide (PVD ou CVD), pourrait alternativement être mise en œuvre après l'étape e). Dans ce cas, la couche électriquement conductrice 5 ne recouvrirait que les portions du dessus du premier niveau du moule multi-niveaux qui sont accessibles par les ouvertures des cavités du moule multi-niveaux.

Selon une variante non représentée dans les figures, une fois la nouvelle couche de résine photosensible 6 développée, il est possible de répéter au moins une fois la partie du procédé correspondant à la séquence d'étapes illustrées par les figures 6 à 10 pour obtenir, si désiré, un moule en résine ayant au moins trois niveaux.

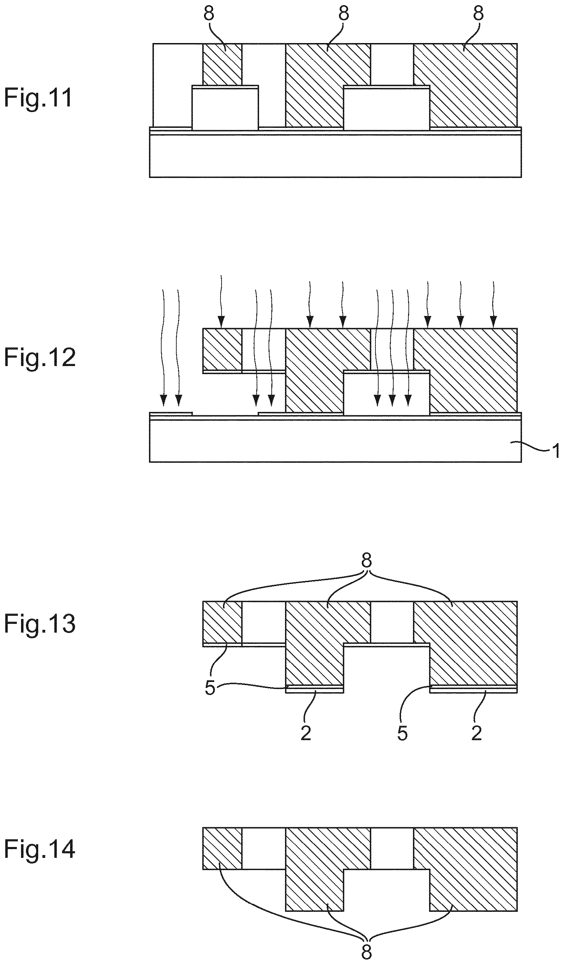

L'étape suivante du procédé (l'étape f) ; fig. 11) consiste à déposer galvaniquement un métal ou un alliage dans les cavités du moule multi-niveaux en résine. On utilise fréquemment comme métal ou alliage pour l'électroformage le nickel, le cuivre, l'or et ses alliages. Le dépôt galvanique est interrompu lorsqu'il arrive à une hauteur déterminée. Cette hauteur peut être égale à la hauteur du moule, mais elle pourrait alternativement être inférieure à la hauteur du moule. Selon une variante avantageuse, préalablement à l'étape du dépôt galvanique, on procède d'abord à l'activation, aussi bien, des surfaces formant les flancs du moule en résine, que des surfaces horizontales métallisées. L'activation des surfaces permet d'améliorer l'amorçage ainsi que la régularité du dépôt galvanique. Typiquement, le métal utilisé pour le dépôt galvanique sera choisi parmi l'ensemble comprenant le nickel, le cuivre, l'or et l'argent, ou encore l'or-cuivre, le nickel-cobalt, le nickel-fer et le nickel-phosphore. L'homme du métier saura déterminer les conditions pour le dépôt galvanique, notamment la composition du bain, la géométrie du système, les tensions et densités de courant, en fonction du métal ou de l'alliage à déposer.

En se reportant à nouveau à la figure 10, on peut voir que les ouvertures structurées dans le moule en résine n'ont pas partout la même profondeur. Certaines parties d'une ouverture laissent apparaître la couche conductrice 2 du substrat 1, alors que d'autres parties de la même ouverture ne s'étendent que jusqu'à la couche conductrice 5 qui recouvre le premier niveau de résine photosensible 3. De manière conventionnelle, l'installation de dépôt galvanique est arrangée pour maintenir la couche conductrice 2 du substrat sous tension de manière à ce que cette dernière se comporte comme une cathode. Selon la présente invention, la couche conductrice 5 qui recouvre le premier niveau de résine photosensible n'est de préférence pas reliée à la source de tension. Ainsi, dans une première phase, le dépôt galvanique ne s'effectue que sur la surface conductrice 2. Ce n'est qu'une fois que la couche de métal électro-déposé atteint la hauteur de la première couche de résine qu'elle peut entrer en contact avec la couche conductrice 5 et mettre cette dernière sous tension. Grâce à cette caractéristique, la croissance galvanique dans les différentes parties des ouvertures peut progresser de front, ce qui permet de réaliser des structures avec des surfaces relativement planes.

L'étape suivante du procédé (l'étape g) consiste à libérer la structure métallique multi-niveaux du substrat et de la résine photosensible. Conformément au mode de mise en œuvre illustré, cette étape comprend une sous-étape consistant à éliminer la résine formant le moule multi-niveaux de manière à faire apparaître la structure métallique multi-niveaux 8 (fig. 12). Conformément au présent exemple, cette étape est réalisée par décapage au plasma. On comprendra toutefois que le « stripping » peut être réalisé de plusieurs autres manières, par exemple par voie chimique ou physique.

L'étape g) comprend ensuite une autre sous-étape qui consiste à détacher la structure métallique multi-niveaux 8 du substrat 2 (fig. 13). Conformément au présent exemple, le substrat est une plaquette de silicium. Dans ces conditions, il est possible par exemple d'éliminer le substrat par dissolution dans un bain d'hydroxyde de potassium (KOH). On comprendra toutefois que, selon les matériaux utilisés, il est souvent possible de détacher la structure métallique multi-niveaux 8 simplement par délaminage ou encore par sous-gravure sélective de la couche conductrice 2. C'est le cas notamment lorsque le substrat est une plaquette métallique massive. Précisions encore que selon d'autres modes de mise en œuvre du procédé de l'invention, on effectue le retrait (stripping) de la résine après l'étape de dissolution du substrat en silicium.

Conformément à une variante de mise en œuvre non représentée, il est possible de détacher la structure métallique multi-niveaux 8 du substrat 2 avant de procéder au stripping de la résine. Cette variante permet notamment de placer les pièces métalliques sur un nouveau support tout en conservant le positionnement relatif des pièces.

Conformément au présent exemple, l'étape g) comprend ensuite une autre sous-étape consistant à placer la structure métallique multi-niveaux 8 dans un bain prévu pour éliminer les parties restantes des couches d'amorçage 2 et 5 (fig. 14).

On comprendra en outre que diverses modifications et/ou améliorations évidentes pour un homme du métier peuvent être apportées au mode de mise en œuvre qui fait l'objet de la présente description sans sortir du cadre de la présente invention définie par les revendications annexées.

## Revendications

1. Procédé de fabrication par technologie LIGA d'une microstructure métallique multi-niveaux (8), comportant les étapes suivantes :
a) se munir d'un substrat (1) comportant une face supérieure (2) électriquement conductrice ;
b) déposer une première couche de résine photosensible (3) sur la face supérieure (2) du substrat ;
c) structurer la première couche de résine photosensible (3), afin de réaliser un premier niveau d'un moule multi-niveaux comportant des cavités traversantes laissant apparaître la surface conductrice (2) du substrat ;
d) déposer une nouvelle couche de résine photosensible (6) sur le niveau réalisé du moule multi-niveaux, de manière à le recouvrir et à remplir les cavités ;
e) structurer la nouvelle couche de résine photosensible afin de réaliser un niveau additionnel du moule multi-niveaux comportant des cavités traversantes laissant apparaître la surface conductrice (2) du substrat ;
f) une surface électriquement conductrice (5) ayant été préalablement formée, durant une étape antérieure, sur les portions accessibles du dessus du premier niveau du moule multi-niveaux, remplir de métal les cavités du moule multi-niveaux par dépôt galvanique de manière à former une structure métallique multi-niveaux (8) ;
g) libérer la structure métallique multi-niveaux (8) du substrat (1) et de la résine photosensible ;
**caractérisé en ce qu'**il comporte entre l'étape d) et l'étape e) une étape additionnelle de :
x) placer le substrat (1) portant les couches de résines photosensibles (3, 6) dans une étuve sous vide pour une durée comprise entre quelques minutes et plusieurs heures, de manière à produire une mise à plat de la nouvelle couche de résine (6).

2. Procédé de fabrication d'une microstructure métallique conforme à la revendication 1, **caractérisé en ce que** l'étape additionnelle (x) est mise en œuvre à température ambiante.

3. Procédé de fabrication d'une microstructure métallique conforme à la revendication 2, **caractérisé en ce qu'**il comporte entre l'étape additionnelle (x) et l'étape e) une étape de :
y) effectuer dans l'étuve sous vide un précuit de la nouvelle couche de résine (6).

4. Procédé de fabrication d'une microstructure métallique conforme à l'une quelconque des revendications 1, 2 et 3, **caractérisé en ce qu'**il comporte entre l'étape b) et l'étape c) une étape de :
z) effectuer un précuit de la première couche de résine (3).

5. Procédé de fabrication d'une microstructure métallique conforme à l'une quelconque des revendications précédentes, **caractérisé en ce que** l'étape de former une surface électriquement conductrice (5) sur les portions accessibles du dessus du premier niveau du moule multi-niveaux, est mise en œuvre entre l'étape c) et l'étape d) sous la forme du dépôt d'une couche métallique par PVD ou CVD.

6. Procédé de fabrication d'une microstructure métallique conforme à l'une quelconque des revendications 1 à 4, **caractérisé en ce que** l'étape de former une surface électriquement conductrice (5) sur les portions accessibles du dessus du premier niveau du moule multi-niveaux, est mise en œuvre entre l'étape e) et l'étape f) sous la forme du dépôt d'une couche métallique par PVD ou CVD.

7. Procédé de fabrication d'une microstructure métallique conforme à l'une quelconque des revendications précédentes, **caractérisé en ce que** l'étape g) comprend une première et une deuxième sous-étape de respectivement :
g1) éliminer la résine formant le moule multi-niveau de manière à faire apparaître la structure métallique multi-niveaux ;
g2) détacher la structure métallique du substrat (1).

8. Procédé de fabrication d'une microstructure métallique conforme à l'une quelconque des revendications précédentes, **caractérisé en ce qu'**une fois l'étape e) réalisée, la séquence du procédé commençant par l'étape d) et se terminant par l'étape e) est mise en œuvre une nouvelle fois avant de passer à l'étape f) de manière à ajouter une couche supplémentaire au moule multi-niveaux.

9. Procédé de fabrication d'une microstructure métallique conforme à l'une quelconque des revendications précédentes, **caractérisé en ce que** la microstructure métallique multi-niveaux (8) est une pièce de micromécanique horlogère.

10. Procédé de fabrication d'une microstructure métallique conforme à la revendication 9, **caractérisé en ce que** la pièce de micromécanique horlogère est choisie parmi les roues d'échappement et les ancres.

## Patentansprüche

1. Verfahren zur Herstellung einer mehrschichtigen metallischen Mikrostruktur (8) durch LIGA-Technologie, umfassend die folgenden Schritte:
a) Bereitstellen eines Substrats (1), das eine elektrisch leitfähige obere Oberfläche (2) aufweist,
b) Aufbringen einer ersten lichtempfindlichen Harzschicht (3) auf die obere Oberfläche (2) des Substrats,
c) Strukturieren der ersten lichtempfindlichen Harzschicht (3), um eine erste Schicht einer mehrschichtigen Form zu erstellen, die Durchgangshohlräume aufweist, die die leitfähige Oberfläche (2) des Substrats erscheinen lassen,
d) Aufbringen einer neuen lichtempfindlichen Harzschicht (6) auf die Schicht, die von der mehrschichtigen Form erstellt wird, derart, um sie zu bedecken und um die Hohlräume auszufüllen,
e) Strukturieren der neuen lichtempfindlichen Harzschicht, um eine zusätzliche Schicht der mehrschichtigen Form zu erstellen, die Durchgangshohlräume aufweist, die die leitfähige Oberfläche (2) des Substrats erscheinen lassen,
f) nachdem zuvor eine elektrisch leitfähige Oberfläche (5) während eines vorherigen Schrittes auf den Abschnitten gebildet worden ist, die von der Oberseite der ersten Schicht der mehrschichtigen Form zugänglich sind, Füllen der Hohlräume der mehrschichtigen Form mit Metall durch galvanisches Abscheiden, derart, um eine mehrschichtige metallische Struktur (8) zu bilden,
g) Befreien der mehrschichtigen metallischen Struktur (8) von dem Substrat (1) und dem lichtempfindlichen Harz,
**dadurch gekennzeichnet, dass** es zwischen dem Schritt d) und dem Schritt e) einen zusätzlichen Schritt aufweist des:
x) Anordnens des Substrats (1), das die lichtempfindlichen Harzschichten (3, 6) trägt, in einem Vakuumschrank für eine Dauer zwischen einigen Minuten und mehreren Stunden, derart um eine Abflachung der neuen Harzschicht (6) zu erzeugen.

2. Verfahren zur Herstellung einer metallischen Mikrostruktur nach Anspruch 1, **dadurch gekennzeichnet, dass** der zusätzliche Schritt (x) bei Raumtemperatur umgesetzt wird.

3. Verfahren zur Herstellung einer metallischen Mikrostruktur nach Anspruch 2, **dadurch gekennzeichnet, dass** es zwischen dem zusätzliche Schritt (x) und dem Schritt e) einen Schritt aufweist des:
y) Durchführens eines Vortemperns der neuen Harzschicht (6) in dem Vakuumschrank.

4. Verfahren zur Herstellung einer metallischen Mikrostruktur nach einem der Ansprüche 1, 2 und 3, **dadurch gekennzeichnet, dass** es zwischen dem zusätzliche Schritt b) und dem Schritt c) einen Schritt aufweist des:
z) Durchführens eines Vortemperns der ersten Harzschicht (3).

5. Verfahren zur Herstellung einer metallischen Mikrostruktur nach einem der vorhergehenden Ansprüche, **dadurch gekennzeichnet, dass** der Schritt des Bildens einer elektrisch leitfähigen Oberfläche (5) auf den Abschnitten, die von der Oberseite der ersten Schicht der mehrschichtigen Form zugänglich sind, zwischen dem Schritt c) und dem Schritt d) in Form von dem Abscheiden einer metallischen Schicht durch PVD oder CVD umgesetzt wird.

6. Verfahren zur Herstellung einer metallischen Mikrostruktur nach einem der Ansprüche 1 bis 4, **dadurch gekennzeichnet, dass** der Schritt des Bildens einer elektrisch leitfähigen Oberfläche (5) auf den Abschnitten, die von der Oberseite der ersten Schicht der mehrschichtigen Form zugänglich sind, zwischen dem Schritt e) und dem Schritt f) in Form von dem Abscheiden einer metallischen Schicht durch PVD oder CVD umgesetzt wird.

7. Verfahren zur Herstellung einer metallischen Mikrostruktur nach einem der vorhergehenden Ansprüche, **dadurch gekennzeichnet, dass** der Schritt g) einen ersten und einen zweiten Unterschritt aufweist jeweils des:
g1) Entfernens des Harzes, das die mehrschichtige Form bildet, derart, um die mehrschichtige metallische Struktur erscheinen zu lassen,
g2) Ablösens der metallischen Struktur von dem Substrat (1).

8. Verfahren zur Herstellung einer metallischen Mikrostruktur nach einem der vorhergehenden Ansprüche, **dadurch gekennzeichnet, dass**, nachdem der Schritt e) durchgeführt worden ist, die Abfolge des Verfahrens, die mit dem Schritt d) beginnt und mit dem Schritt e) endet, ein weiteres Mal durchgeführt wird, bevor mit Schritt f) fortgefahren wird, derart, um eine zusätzliche Schicht zur mehrschichtigen Form hinzuzufügen.

9. Verfahren zur Herstellung einer metallischen Mikrostruktur nach einem der vorhergehenden Ansprüche, **dadurch gekennzeichnet, dass** die mehrschichtige metallische Mikrostruktur (8) eine mikromechanische Uhrkomponente ist.

10. Verfahren zur Herstellung einer metallischen Mikrostruktur nach Anspruch 9, **dadurch gekennzeichnet, dass** die mikromechanische Uhrkomponente aus den Hemmungsrädern und den Ankern ausgewählt ist.

## Claims

1. Method for producing a multi-level metal micro-structure (8) by LIGA technology, comprising the following steps:
a) obtaining a substrate (1) comprising an electrically conductive upper face (2);
b) depositing a first layer of photosensitive resin (3) on the upper face (2) of the substrate;
c) patterning the first layer of photosensitive resin (3) in order to produce a first level of a multi-level mould comprising through-going cavities allowing the conductive surface (2) of the substrate to be seen;
d) depositing a new layer of photosensitive resin (6) on the produced level of the multi-level mould so as to cover and fill the cavities;
e) patterning the new layer of photosensitive resin in order to produce an additional level of the multi-level mould comprising through-going cavities allowing the conductive surface (2) of the substrate to be seen;
f) with an electrically conductive surface (5) having been previously formed, during an earlier step, on the accessible portions of the top of the first level of the multi-level mould, filling the cavities of the multi-level mould with metal by electrodeposition so as form a multi-level metal structure (8);
g) releasing the multi-level metal structure (8) from the substrate (1) and from the photosensitive resin;
**characterised in that**, between step d) and step (e), it comprises an additional step of:
x) placing the substrate (1) bearing the photosensitive resin layers (3, 6) in a kiln under vacuum for a duration of between a few minutes and several hours so as to produce levelling of the new resin layer (6).

2. Method for producing a metal micro-structure as claimed in claim 1, **characterised in that** the additional step (x) is carried out at ambient temperature.

3. Method for producing a metal micro-structure as claimed in claim 2, **characterised in that**, between additional step (x) and step (e), it comprises a step of:
y) effecting, in the kiln under vacuum, pre-curing of the new resin layer (6).

4. Method for producing a metal micro-structure as claimed in any one of claims 1, 2 and 3, **characterised in that**, between step b) and step (c), it comprises a step of:
z) effecting pre-curing of the first resin layer (3).

5. Method for producing a metal micro-structure as claimed in any one of the preceding claims, **characterised in that** the step of forming an electrically conductive surface (5) on the accessible portions of the top of the first level of the multi-level mould is carried out between step c) and step d) in the form of the deposition of a metal layer by PVD or CVD.

6. Method for producing a metal micro-structure as claimed in any one of claims 1 to 4, **characterised in that** the step of forming an electrically conductive surface (5) on the accessible portions of the top of the first level of the multi-level mould is carried out between step e) and step f) in the form of the deposition of a metal layer by PVD or CVD.

7. Method for producing a metal micro-structure as claimed in any one of the preceding claims, **characterised in that** step g) comprises a first and a second sub-step of respectively:
g1) removing the resin forming the multi-level mould so as to expose the multi-level metal structure;
g2) detaching the metal structure from the substrate (1).

8. Method for producing a metal micro-structure as claimed in any one of the preceding claims, **characterised in that**, once step e) has been carried out, the sequence of the method beginning with step d) and terminating with step e) is carried out once again before passing to step f) so as to add an additional layer to the multi-level mould.

9. Method for producing a metal micro-structure as claimed in any one of the preceding claims, **characterised in that** the multi-level metal microstructure (8) is a micro-mechanical timepiece part.

10. Method for producing a metal micro-structure as claimed in claim 9, **characterised in that** the micro-mechanical timepiece part is selected from among escapement wheels and pallets.
